Europäisches Patentamt

European Patent Office

Office européen des brevets

(11) Publication number: **0 385 200**

**A2**

# (12) EUROPEAN PATENT APPLICATION

(21) Application number: **90103046.0**

(22) Date of filing: **16.02.90**

(51) Int. Cl.⁵: **G05B 19/05**

(30) Priority: **01.03.89 JP 46509/89**

(43) Date of publication of application:
**05.09.90 Bulletin 90/36**

(84) Designated Contracting States:
**CH DE ES FR GB IT LI NL SE**

(71) Applicant: **HITACHI, LTD.**
**6, Kanda Surugadai 4-chome**
**Chiyoda-ku, Tokyo 100(JP)**

(72) Inventor: **Fujiwara, Katuhiro**
**3-20-21 Oojidai**
**Sakurashi, Chiba(JP)**
Inventor: **Itou, Atusi**
**3-406 5-39 Narashinodai**
**Hunabashishi, Chiba(JP)**
Inventor: **Osako, Kazuyosi**
**5-1-33 Sakushindai**
**Chibashi, Chiba(JP)**

(74) Representative: **Strehl, Schübel-Hopf,**
**Groening**
**Maximilianstrasse 54 Postfach 22 14 55**
**D-8000 München 22(DE)**

(54) **Programmable controller with detachable display unit.**

(57) A programmable controller includes a plurality of input/output units (2a, 2b) operating as function units to receive input condition signals from a controlled object and supply output control signals thereto so as to control the object in accordance with a predetermined sequence. Display units (3b) are provided for each function unit (2a, 2b) to display the state of the received input condition signals and the state of the output control signals. To improve packaging density, the function units (2a, 2b) of the same size are disposed in a stacked manner. To facilitate the stacking of the function units (2a, 2b), the display units (3b) are provided as physically separate detachable units which are mounted on the uppermost function unit (2a) of the stack and connected to a respective function unit by way of an external line.

FIG. 14 (b)

## PROGRAMMABLE CONTROLLER WITH DETACHABLE DISPLAY UNIT

### BACKGROUND OF THE INVENTION

The present invention relates in general to a programmable controller for controlling a device, process or system in a predetermined sequence under control of a stored program, and more particularly to a programmable controller of the type which is capable of effectively displaying operating conditions of the controller.

A programmable sequence controller typically includes one or more input/output units, each of which are connected to an object to be controlled to receive therefrom input condition signals representing operating conditions of the object and to supply thereto output control signals to control the operating condition of the object. The input/output units are connected to a main arithmetic unit, which monitors the input condition signals received at each input/output unit and supplies to the input/output unit output control signals generated in accordance with the state of the input condition signals under control of a stored program.

It is often necessary or desirable for an operator to monitor the state of the input condition signals and/or output control signals at each input/output unit, not only to ensure that the controlled object is being properly controlled or to indicate a current state of operation thereof at any given time, but also to facilitate troubleshooting in the case where a malfunction of the controlled object occurs. For this purpose, it has been known to incorporate a monitor display circuit into each input/output unit to provide a visual indication of the status of each input and output signal coming into and being sent out from the respective input/output units. Further, it has been proposed in Japanese Laid-open Patent Publication No. 53-117181 that a monitor display circuit be provided for the main arithmetic unit as well, to display operating conditions of the main arithmetic unit, thereby providing a more rapid determination of the overall operation of the programmable controller as well as facilitating a simulation of the sequence program. These monitor display circuits include sets of light emitting diodes (LED) provided on an upper surface of the unit to indicate the state of various relays in the unit.

The input/output units and the main arithmetic unit, operating as function units within the programmable controller, have been mounted physically in a side-by-side or juxtaposed manner on a mother board to facilitate observation of the LED display provided by the monitor display circuit of each function unit. However, such an arrangement of function units provides for a poor packaging density, which leads to an increase in the size of the programmable controller. On the other hand, while the packaging density could be greatly improved by stacking function units on the mother board, such an arrangement would result in a blocking of the LED display for all but the top function unit of the stack. Another possible solution is to provide different size function units, so that function units could be stacked in a pyramid-like manner leaving a portion of the surface of each function unit exposed for viewing of the LED display thereof; however, this results in the need to manufacture different size function units, which increases the cost of manufacture.

Thus, the conflicting considerations affecting packing density, visibility of the LED displays and the manufacturing cost have posed problems in the design of programmable controllers.

### SUMMARY OF THE INVENTION

It is a primary object of the present invention to provide a programmable controller of the type described which provides for high packaging density and simultaneous viewing of the LED displays for all function units without increase in manufacturing costs.

It is another object of the present invention to provide a programmable controller of the type described which facilitates correlation between individual LED displays and the corresponding signal terminals monitored thereby.

It is a further object of the present invention to provide a programmable controller of the type described in which the positioning of a display unit on a function unit is adjustable to facilitate system monitoring and control.

To achieve the foregoing objects, the programmable controller of the present invention is characterized by the provision of physically separable display units for the respective function units, each display unit being capable of being detachably mounted on a function unit and electrically connected thereto by way of external conductors. Further, a function unit is constructed to have a plurality of display units mounted thereon at the same time, which also provides the possibility of mounting a single display unit selectively at different mounting positions on a particular function unit.

With this particular construction of the monitor units and function units, a plurality of advantageous features are achieved. One feature relates to the ability to vertically stack function units of the same size on the mother board while also providing for viewing of all display units associated with the stacked function units. For this purpose, the plurality of display units associated with the stacked function units are all mounted on the function unit at the top of the stack and are connected electrically to the respective function units by external conductors. This provides for high packaging density with the use of function units of a single size.

A further feature of the present invention resides in the ability to mount a display unit at different locations on a function unit. A function unit will typically include an input connector block and an output connector block mounted on opposite sides of the unit with each connection block including a plurality of terminals aligned in a row. The display unit is typically of smaller size than the function unit and includes parallel rows of LEDs corresponding to the input and output terminals. By making it possible to selectively mount the display unit either adjacent to the input connector block or the output connector block, it is possible to bring the row of LEDs into closer proximity to its associated connector block, so that monitoring of the condition of the respective signal states is facilitated.

By means of the present invention, it is possible to mount function units of the same size in a stacked manner to provide an increased packaging density, while ensuring a visible display for all units by mounting all display units for the functional units on the topmost functional unit of the stack. Further, since a display unit can be selectively attached to a position on the functional unit associated with the displayed object, it is easy to confirm the status of the object whose conditions are to be displayed.

These and other objects, features and advantages of the present invention will become more apparent from a description of the preferred embodiments, as illustrated in the accompanying drawings.

## BRIEF DESCRIPTION OF THE DRAWINGS

Fig. 1 is block diagram of a programmable controller of the type to which the present invention is directed;

Fig. 2 is a top elevational view of a main arithmetic unit of a programmable controller according to the present invention;

Fig. 3 is a top elevational view of an input/output unit of a programmable controller according to the present invention;

Fig. 4 is a top elevational view of a display unit of a programmable controller according to the present invention;

Fig. 5 is a schematic block diagram of an input/output unit of a programmable controller;

Fig. 6 is a schematic block diagram of a display unit of a programmable controller;

Fig. 7(a) is a top view and Fig. 7(b) is a sectional view of a portion of the top of the input/output unit according to the present invention;

Fig. 8(a) is a side view and Fig. 8(b) is a top view of the display unit according to the present invention;

Fig. 9 is a partial sectional view showing the connection of one end of a display unit to a functional unit;

Fig. 10 is a partial sectional view showing the connection of the other end of a display unit to a functional unit;

Fig. 11(a) is a top view of a connecting element and Fig. 11(b) is a section view along line a-a' of Fig. 11(a) showing the connecting element mounted on a functional unit;

Fig. 12(a) is a top view of a display unit and Fig. 12(b) is a side view showing a connecting element mounted on the display unit;

Fig. 13 is a side view partly in section showing a display unit mounted on a functional unit using the connecting elements of Figs. 11(b) and 12(b);

Fig. 14(a) is a top plan view and Fig. 14 (b) is a side view of a stack of functional units with associated display units according to the present invention;

Fig. 15 is a top view of a functional unit having a display unit mounted in one position; and

Fig. 16 is a top view of the functional unit of Fig. 15 in which the display unit occupies a different position.

## DESCRIPTION OF THE PREFERRED EMBODIMENTS

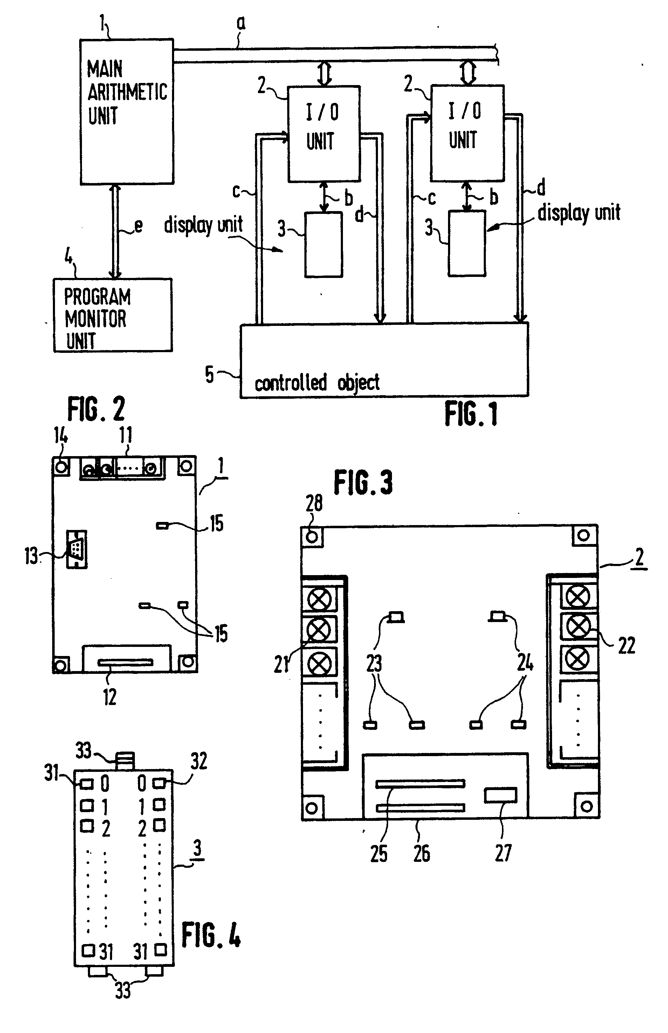

Fig. 1 illustrates the basic configuration of a programmable controller of the type to which the present invention is applied. A controlled object 5, which may be an external process or system, is connected to a plurality of input/output units 2, which operate as a function unit for receiving an input condition signal c from the controlled object 5 and for supplying a control output signal d thereto. The input/output units 2 are connected to a main arithmetic unit 1, which also operates as a function unit, through an input/output bus a. The main arithmetic unit 1 periodically scans the input/output units 2 to fetch input condition signals stored therein and supplies output control signals to the input/output units 2 under control of a stored program.

Each input/output unit 2 is connected to a display unit 3 through a serial signal transmission line b, whereby the state of the input condition signals supplied to the input/output unit 2 and the output control signals transmitted therefrom to the controlled object 5 may be monitored. Further, there is provided a program monitor unit 4 connected to the main arithmetic unit 1 through a signal transmission line 3 for causing the main arithmetic unit to perform desired operations and also for monitoring the operating conditions thereof.

The external appearance of the main arithmetic unit 1 is shown in Fig. 2. A terminal block 11 is provided at one end of the unit for receiving power necessary for operation of the programmable controller, and an input/output connector 12 is located at the opposite end of the unit and is adapted to be connected to the bus a extending to the input/output units 2. A through-hole 14 is provided at each corner of the unit for mounting the unit on a support plate or the like (not shown).

The main arithmetic unit 1 is connected to the program monitor unit 4 by way of a cable forming the signal transmission line e through a peripheral equipment connector 13. The program monitor unit 4 is physically mounted on the unit 1 and coupled thereto by means of three mounting holes 15 by which the program monitor unit 4 is attached, as will be described in more detail hereinafter.

Fig. 3 shows the external appearance of an input/output unit 2. A terminal block 21 is provided at one side of the unit 2 for connection to a cable forming the transmission line c on which input conditions signals are received from the controlled object 5. On the opposite side of the unit 2 there is provided a terminal block 22 which is adapted to be connected to a cable forming the transmission line d for sending output control signals to the controlled object 5. The terminal blocks 21 and 22 provide for connection to a plurality of signal lines corresponding to the number of input condition signals received from and the number of output control signals to be sent to the controlled object 5. As an example, each of the terminal blocks 21 and 22 may provide for connection to thirty-two signal lines. As such, the terminal blocks 21 and 22 represent function blocks within the function unit (input/output unit).

The connection of an input/output unit 2 to the main arithmetic unit 1 and other input/output units 2 via the bus a is effected through a connector 25 or 26; while, the connection of the input/output unit 2 to its associated display unit 3 by way of the serial transmission line b is effected through a connector 27. The display unit 3 is mountable on the input/output unit 2 by means of either a set of three attachment holes 23, whereby the unit 3 is mounted adjacent to the control input terminal block 21, or a set of three attachment holes 24, whereby the display unit 3 is mounted adjacent to the control output terminal block 22. Through-holes 28 are provided at the four corners of the unit 2 for purposes of mounting the unit.

Fig. 4 shows the external appearance of a display unit 3. As can be seen, the display unit 3 includes a plurality of input display devices 31 in a row adjacent to the left-hand side for displaying the status of the respective input conditions signals and a plurality of output display devices 32 in a row on the right-hand side of the unit for displaying the status of the respective output control signals. Preferably, the display devices 31 and 32 will each include a number of LEDs corresponding to the number of terminals in the corresponding terminal block, i.e. 32 LEDs in the above-described example. Thus, the display unit 3 makes it possible to observe the status of each of the various signals received by and sent out from the input and output terminal blocks 21 and 22.

Each display unit 3 is provided with claws 33 for mounting the unit 3 in a detachable manner on the input/output unit 2 either by engagement with the mounting apertures 23 or the mounting apertures 24. As will described in more detail hereinafter, by providing a detachable mounting arrangement for the display unit 3, it is possible to locate the display unit 3 on the input/output unit 2 either at a position adjacent the terminal block 21 where the input display devices 31 will be close to the input terminals carrying the input condition signals or at the location adjacent the terminal block 22 where the input display devices 32 will be close to the respective terminals carrying the output control signals.

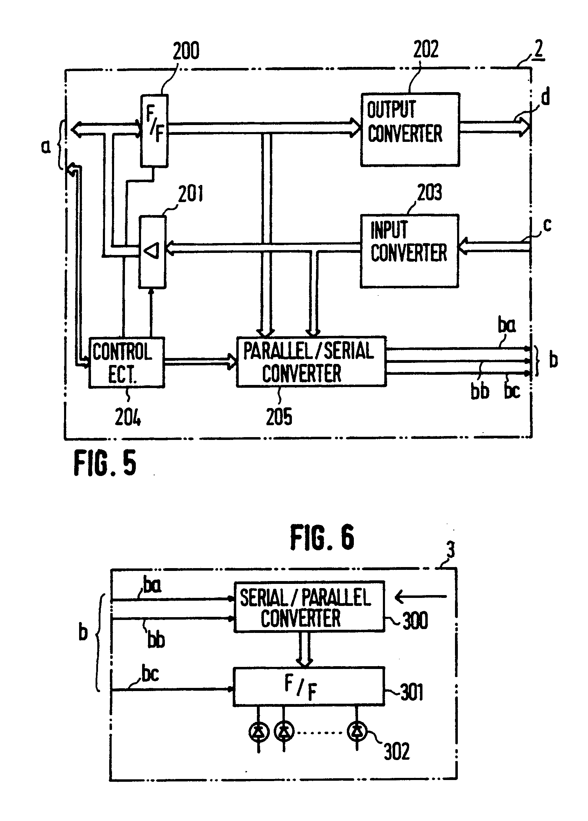

The manner in which input condition signals are transmitted between the input/output unit 2 and the display unit 3 will be described with reference to Figs. 5 and 6, which show details of the input/output unit and the display unit, respectively.

Referring first to Fig. 5, the bus a includes a plurality of data lines which carry data between the main arithmetic unit 1 and the plurality of input/output units 2 and control signal lines which provide signals for timing and control of the input/output operations. The data lines of the bus are connected to a flip-flop circuit 200, which holds the data signals received from the main arithmetic unit 1 and applies these signals to an output converter 202, which supplies the output control signals on line d to the controlled object 5. The data lines of the bus a are also connected to the outputs of a driver circuit 200, which receives input condition signals on line c from the controlled object 5 via the input converter 203. The output control signals supplied from the flip-flop circuit 200 to the output converter 202 and the input condition signals supplied from the input converter 203 to the driver circuit 201 are also supplied to a parallel/serial converter 205. A control circuit 204 receives control signals from the main arithmetic unit 1 via the bus a and selectively controls operation of the flip-flop circuit 200, driver circuit 201 and parallel/serial converter 205.

In response to a command from the main arithmetic unit 1 for transmission of input condition signals from an input/output unit 2, the control circuit 204 enables the driver circuit 201 to supply input condition signals from the input converter 203 to the bus a. When the main arithmetic unit 1 is ready to supply output control signals to the input/output unit 2, a command to the control circuit 204 results in enabling of the flip-flop circuit 200 so that the output control signals on the bus a can be latched. The parallel/serial converter 205 converts the signals latched in the flip-flop circuit 200 and the signal supplied to the driver circuit 201 to serial data and supplies this serial data on the signal line ba of the transmission line b along with a transfer clock signal bb and a display control signal bc. The display control signal bc designates input data or output data under control of the control circuit 204.

Fig. 6 illustrates the internal configuration of the display unit. The serial data line ba and the transfer clock signal bb from the input/output unit 2 are applied to a serial/parallel converter 300 where the serial data is converted to parallel data under control of the transfer clock signal. The data on line ba includes both the status of the input condition signals provided at the output of the input converter 203 and the status of the output control signals provided at the output of the flip-flop circuit 200 in the input/output unit 2, and the parallel data provided at the output of the converter 300 is latched in the flip-flop circuit 301 under control of the display control signal on control line bc. Thus, the LED display 302, which includes both the input display devices 31 and the output display devices 32 displays the status of the input conditions signals and output control signals received by and sent out from the associated input/output unit 2.

While the display unit 3 described with reference to Fig. 6 includes an LED display 302, a liquid crystal display can also be provided in the display unit 3. Since a liquid crystal display is capable of providing various types of displays in a simple manner, a message indicating a sequential processing can be displayed with a liquid crystal display, as well as a display of a sequence abnormality alarm or an announcement of an operation to be performed. Further, the transmission line b can be provided in the form of a shield wire or twisted pair line of the type which is commonly used for transmitting electrical signals; however, in order to provide an anti-noise capability for the transmission path, it is possible to form the transmission line b of optical fibers for transmission of the converted serial data therethrough.

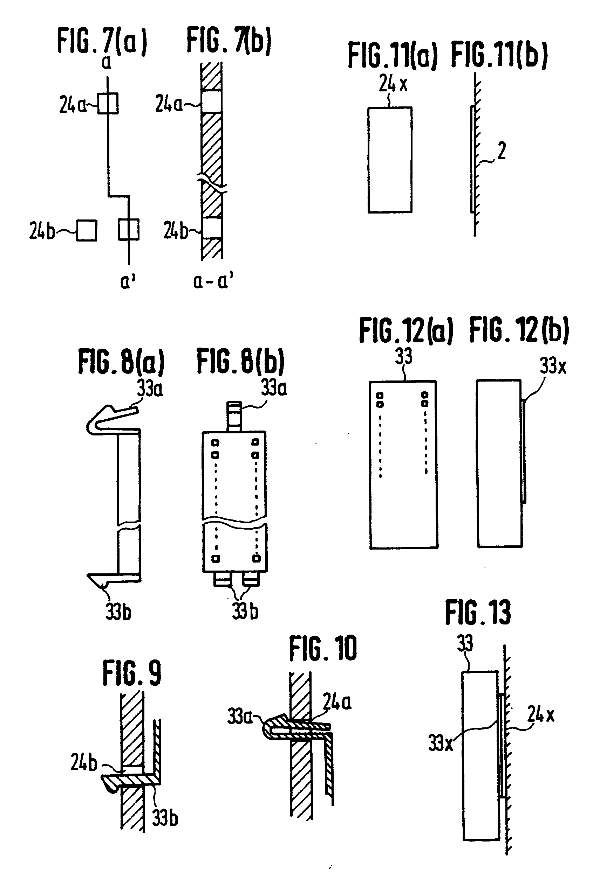

Figs. 7(a) through Fig. 10 illustrate one example of the manner in which a display unit 3 may be mounted on an input/output unit 2. While this description refers to the manner of mounting a display unit 3 on an input/output unit 2, it should also be recognized that a similar mounting may be provided for the program monitor unit 4 on the main arithmetic unit 1. As seen in Figs. 7(a) and 7-(b), the input/output unit 2 is provided on its outer surface with square through-holes 24a and 24b disposed in a triangular pattern, as also shown in Fig. 3. Figs. 8(a) and 8(b) show more clearly that the display unit 3 is provided with two fixed claws 33b and one spring claw 33a for mechanically coupling the display unit 3 to the input/output unit 2. When attaching the display unit 3 to the input/output unit 2, first the fixed claws 33b are inserted into the holes 24b, as shown in Fig. 9, so that the claws engage within these holes, and then the spring claw 33a is inserted into the hole 24a, as shown in Fig. 10. Once the spring claw 33a is inserted into the hole 24a, the spring force of the claw 33a will cause it to expand in the longitudinal direction of the display unit 3 so as to removably lock the display unit 3 onto the outer casing of the input/output unit 2. By making 3n (3 = 2, 3, or more) square holes at suitable intervals in the input/output unit 2 (or the main arithmetic unit 1 or other mechanisms or units), n display units can be attached to the casing of a single unit. The advantages of such an arrangement in accordance with the present invention will be described in more detail hereinafter.

Another arrangement for mounting a display unit 3 on an input/output unit 2 is shown in Figs. 11(a)-13. As seen in Figs. 11(a) and 11(b), an iron plate 24x may be bonded or fixed in some manner onto the outer surface of the casing of the input/output unit 2. Further, a permanent magnet plate 33x may be bonded or secured in some manner to the rear surface of the display unit 33, as seen in Figs. 12(a) and 12(b). The display unit 3 may be then mounted on the input/output unit 2 by positioning the display unit 3 so that the permanent magnet plate 33x thereof engages with the iron plate 24x mounted on the input/output unit, as seen in Fig. 13. Further, if the iron plate 24x is sufficiently large to cover the major portion of the surface of the input/output unit 2, or if a portion of the casing of the input/output unit 2 is made of a ferrous metal, the display unit 3 can be attached at any position on the input/output unit 2 without requiring a special attachment mechanism, such as the arrangement shown in Figs. 7(a)-10.

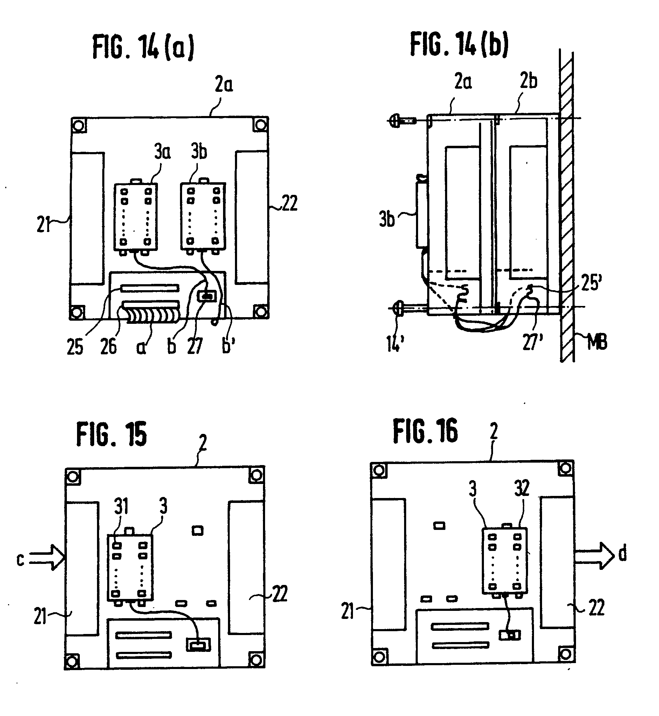

Now, various exemplary embodiments of the programmable controller will be described with reference to Figs. 14(a), 14(b), 15 and 16 to illustrate the features of the present invention.

Figs. 14(a) and 14(b) illustrate a programmable controller in which a pair of input/output units 2a and 2b of the same size are mounted in a stacked manner on a mother board MB. The stacked units are secured to the mother board MB by retaining screws 14' inserted through the mounting holes 14 at the corners of the respective units. On the uppermost input/output units 2a, there are mounted the display units 3a and 3b in side-by-side arrangement, with the transmission line b of the display unit 3a being connected to the connector 27 of the input/output unit 2 and the transmission line b' of the display unit 3b being connected to a similar connector 27' on the unit 2b. The bus a from the main arithmetic unit 1 is coupled to the connector 26' of the input/output unit 2a and to the connector 25' of the input/output unit 2b.

With the arrangement shown in Figs. 14(a) and 14(b), a maximum packaging density of the units with respect to the mounting surface of the mother board MB is achieved, while also providing on unimpeded viewing of each of the display units 3a and 3b associated with the respective input/output units 2a and 2b forming the unit stack. While the illustrated example provides for a stacking of two input/output units, it will be appreciated that the stacking of three or more units is also possible where the surface area of an input/output unit affords the mounting of a similar number of display units. In this regard, while it might be necessary to increase the size of an input/output unit to accommodate a larger number of display units to increase the size of the stack, it will be appreciated that such increase in size of an input/output unit will be far less than the area occupied by the units if mounted on the mother board MB in a juxtaposed manner.

Figs. 15 and 16 illustrate a further feature of the present invention which involves the selective mounting of a display unit 3 at different positions on an input/output unit 2. In Fig. 15, the display devices 31 corresponding to the input condition signals on line c are mounted at a position adjacent to the control block 21, i.e. at a position closer to the respective input terminals of the block 21, so that the state of the input condition signals on line c can be more easily confirmed. On the other hand, Fig. 16 shows the display unit 3 mounted at a position adjacent to the terminal block 22, i.e. at a position where the LEDs 32 are closer to the respective terminals of the block 22. In either case, checking and confirmation of the status of the signals at the respective terminals are easily performed because the positions through which the actual signals are transmitted and the display therefore are located in close proximity to each other. Thus, by providing for a detachable mounting of the display units 3 on the input/output units 2, it is possible to selectively move the display units 3 so as to be in close proximity to the terminals carrying the signals to be monitored.

As can be seen from the foregoing description of the present invention, the packaging density of input/output units can be increased by stacking these units on the mother board, and by mounting the display units associated with each input/output unit of the stack on the surface of the input/output unit located at the top of the stack, the displays relating to the input and output signals for each input/output unit can be easily seen. Further, the detachable mounting of the display units at selectable positions on an input/output unit makes it possible to move the display unit closer to the position where the signals to be monitored are received at the terminal block, thereby facilitating a confirmation of the status of each signal as it is received or sent out from the input/output unit.

While we have shown and described various embodiments in accordance with the present invention, it is understood that the same is not limited thereto but is susceptible of numerous changes and modifications as known to one having ordinary skill in the art and we therefore do not wish to be limited to the details shown and described herein, but intend to cover all such modifications as are encompassed by the scope of the appended claims.

## Claims

1. A programmable controller having at least one function unit (2) for delivering control signals to, and for receiving condition signals from, a controlled object (5) so as to operate the controlled object (5) according to a predetermined sequence, a display unit (3) for displaying an operating condition of the function unit (2), said display unit (3) being arranged physically separate from and independent of said function unit (2), coupling means (23, 24, 33) for detachably attaching said display unit (3) on an outer surface of said function unit (2), and transmission means (b) coupled between said function unit (2) and said display unit (3) for transmitting an operating condition singal from said function unit (2) to said display unit (3).

2. The controller of claim 1, wherein a plurality of function units (2a, 2b) of the same size are mounted on a mounting surface of a support member (MB) in a stacked manner.

3. The controller of claim 2, including a plurality of display units (3a, 3b) for displaying operating conditions of the respective function units (2a, 2b), said plurality of display units (3a, 3b) all being detachably attached onto an outer surface of the function unit (2a) positioned at the top of the stack.

4. The controller of claim 3, wherein said transmission means comprises a plurality of signal cables (b, b') each coupled between a display unit (3a, 3b) and a respective one of said stacked function units (2a, 2b).

5. The controller of claim 4, wherein said signal cables (b, b') are electrical signal conductors, or fiber optic conductors.

6. The controller of any one of claims 1 to 5, wherein said coupling means includes a plurality of claws (33a, 33b) provided on said display unit (3) for engaging apertures (23, 24) provided in the outer surface of said function unit (2), one of said claws (33a) being a spring claw so as to permit a detaching of said display unit (3) from said function unit (2).

7. The controller of any one of claims 1 to 5, wherein said coupling means includes a magnetic member (33X) attached to one (3) of said display unit and said function unit, and a metal member (24X) attached to the other (2) of said display unit and said function unit for detachably coupling with said magnetic member (33X).

8. The controller of any one of claims 1 to 7, wherein said coupling means includes a first coupling part (33) on said display unit (3), and at least one second coupling part (23, 24) on said function unit (2) for coupling with said first coupling part (33).

9. The controller of claim 8, wherein plural second coupling parts (23, 24) are provided on said function unit (2) so that a display unit (3) may be attached to said function unit (2) at selectively different locations.

10. The controller of claim 9, wherein said function unit (2) includes first and second connector blocks (21, 22) each including a plurality of terminals to which signal lines (c, d) may be connected, and said display unit (3) includes a first display arrangement (31) for displaying the state of signals at the terminals of said first connector block (21) and a second display arrangement (32) for displaying the state of signals at the terminals of said second connector block (22).

11. The controller of claim 10, wherein a second coupling part (23, 24) is disposed on said function unit (2) at positions adjacent each of said first and second connector blocks (21, 22) so that said display unit (3) may be selectively attached to said function unit (2) close to said first connector block (21) or said second connector block (22) depending on the signals to be monitored.

## FIG.1

MAIN ARITHMETIC UNIT

1

a

2

I / O UNIT

2

I / O UNIT

c

b

d

display unit

3

c

b

d

display unit

3

e

4

PROGRAM MONITOR UNIT

5

controlled object

## FIG. 2

14

11

1

15

13

15

12

## FIG.3

28

2

21

23

24

22

25 26 27

## FIG. 4

33

31

32

0    0
1    1
2    2

3

31    31

33

FIG. 5

FIG. 6

FIG. 7(a)  FIG. 7(b)  FIG.11(a)  FIG.11(b)

FIG.12(a)  FIG.12(b)

FIG.8(a)  FIG.8(b)

FIG.9  FIG.10  FIG.13

FIG. 14 (a)

FIG. 14 (b)

FIG. 15

FIG. 16